# EUROPÄISCHE PATENTSCHRIFT

(11) **EP 0 844 469 B1**
(45) Veröffentlichungstag und Bekanntmachung des Hinweises auf die Patenterteilung: **05.06.2002**
(21) Anmeldenummer: 97120446.6
(22) Anmeldetag: 21.11.1997
(51) Int. Cl.: G01L 5/00, H01L 21/48, C23C 14/06, B23Q 17/09, G01K 1/14

(54) **Beschichtete, mechanisch beanspruchbare Komponenten oder Elemente sowie Verfahren zum Herstellen von solchen Komponenten oder Elementen**
Coated high-performance structural elements or components and method of manufacturing such elements or components
Eléments de construction ou composantes revêtus et soudables à haute résistance mécanique et procédé de fabrication de tels éléments ou composantes

(30) Priorität: 21.11.1996 DE 19648286; 21.11.1996 DE 19648287
(43) Veröffentlichungstag der Anmeldung: 27.05.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: Lüthje, Holger, Dipl.-Ing., 25469 Halstenbek (DE)
(74) Vertreter: Einsel, Martin, Dipl.-Phys.

(56) Entgegenhaltungen:
- EP-A- 0 258 215
- EP-A- 0 685 297
- WO-A-95/32409
- CAMBRIL E ET AL: "LASER WRITING ON GOLD-CONTAINING HYDROCARBON FILMS" JOURNAL OF PHYSICS D. APPLIED PHYSICS, Bd. 26, Nr. 1, 14.Januar 1993, Seiten 149-153, XP000335784

## Beschreibung

Die Erfindung betrifft mechanisch beanspruchbare Komponenten oder Elemente sowie ein Verfahren zum Herstellen von mechanisch beanspruchbaren Komponenten und Elementen mit einem mit tribologischer Beschichtung zu beschichtenden Substrat und eine Vorrichtung zur Durchführung des Verfahrens.

Derartige Komponenten und Elemente können Maschinenkomponenten und Maschinenbauteile oder Werkzeuge verschiedenster Art und deren Bauteile sein. Diese unterliegen während des Betriebes Belastungen, die sehr unterschiedlich sind und oft in extremer Weise nur lokal auftreten. Diese Belastungen können abhängig von der jeweiligen Anwendung unterschiedlich gestaltet sein, wie beispielsweise mechanisch, thermisch, elektrisch oder chemisch. All diese Belastungen führen bei Überschreiten der spezifischen Grenzwerte zum Verschleiß und zur Deformation der Bauteile. Daher ist es wünschenswert, durch eine integrierte Zustandssensorik die jeweiligen Belastungszustände zu messen und damit eine geeignete Steuerung der Maschinen bzw. der Komponenten oder Werkzeuge oder Elemente vorzunehmen. Dabei ist es insbesondere aufgrund der oft nur lokal auftretenden Belastungen wichtig, die Messungen in den Hauptbelastungszonen durchzuführen.

Neben Messungen von belastungsrelevanten Größen wie beispielsweise Verschleiß, Kraft, Drehmoment, Vibration und Temperatur sind oftmals positionsbezogene Größen von entscheidender Bedeutung für die Steuerung von Maschinen. Hierzu gehören unter anderem Angaben zum Drehwinkel und zum Verfahrweg.

Es ist daher bekannt, um die zum Teil hohen Anforderungen an mechanische Komponenten erfüllen zu können, Oberflächenbeschichtungen vorzunehmen, welche es aufgrund der optimierten Materialeigenschaften der Schichten selbst erlauben, die Funktionalität der Bauteile zu verbessern. Hierbei werden insbesondere Hartstoffschichten verwendet, die eine breite Anwendung im Bereich der Schneidwerkzeuge aufweisen.

Aus der EP 0 258 215 B1 ist eine Kombination von einer Dünnschichtsensorik mit einer Verschleißschutzbeschichtung bekannt, wobei die Dünnschichtsensorik auf mehreren elektrisch angepaßten und lithographisch strukturierten Schichten aufgebaut ist. In dieser Schrift wird ein Verfahren beschrieben, bei welchem elektrische Leiter, welche als Zustandswandler wirken, an der Oberfläche einer Komponente so angebracht werden, daß sie ein elektrisches Signal aussenden können zur Angabe des gemessenen Zustandes der Komponente. Sie offenbart darüber hinaus, daß an der Oberfläche der Komponente ein oder mehrere mikroelektronische Kreise, welche an die elektrischen Leiter angeschlossen sind, an eine signalverarbeitende Einrichtung angeschlossen werden. Eine Schutzschicht wird auf zumindest Teilen der Leiter und Kreise durch eine bei der Herstellung von Halbleitern angewandte Technik aufgebracht. Die Schutzschicht besteht dabei beispielsweise aus einer Schicht elektrisch nicht leitenden Materials, welche unmittelbar auf die Kreise und Unterleiter aufgebracht wird und zugleich eine Verschleißschicht ist, die eine oder mehrere Verbindungen von Titannitrid oder Titancarbid oder Aluminiumdioxid enthält. Der Aufbau des Zustandswandlers ist jedoch sehr aufwendig. Für den sensorischen Aufbau müssen mehrere Schichten aus verschiedenen dielektrischen und elektrisch leitenden Materialien verwendet werden. Die Herstellung der mechanischen Komponente erfolgt mit Dünnschichttechniken der Halbleiter- und Schaltungstechnik, welche nicht zu Schichtaufbau und Schichtanbindungen führen, die den hohen mechanischen Erfordernissen von Vergütungs- oder Verschleißschutzschichten für mechanische Komponenten und Werkzeuge entgegentreten können. Der Aufbau der Zustandswandler besteht aus einer Vielzahl von Teilschritten, welche im einzelnen die Herstellung des Wandlers in Form eines Beschichtungsprozesses, gefolgt von Fotolithographie oder Ätzung, die Herstellung von mikroelektronischen Schaltkreisen und Anbringung von Schutzschichten umfaßt. Der Dünnschichtaufbau erfolgt mit Schichtmaterialien und Beschichtungstechniken der Halbleiterindustrie, wobei keine tribologisch optimierten Schichtsysteme zur Anwendung kommen. Der Aufbau kann daher den hohen mechanischen Belastungen von Maschinenkomponenten und Werkzeugen im Zweifel nicht standhalten.

Da mechanische Komponenten und Werkzeuge in der täglichen Praxis zum überwiegenden Teil aus elektrisch leitenden Materialien, wie beispielsweise Stahl, Aluminium oder Hartmetall, bestehen, werden zusätzlich elektrisch isolierende Schichten aufgebracht, welche ggf. noch strukturiert werden. Es ist nämlich bekannt, daß Mehrschichtaufbauten infolge ihrer unterschiedlichen metallischen Eigenschaften zu unterschiedlichen intrinsischen mechanischen Spannungen in den Grenzzonen der verschiedenen Schichten führen. Diese wiederum können bei mechanischer und thermischer Belastung zu einer Delamination der Schichten führen.

Aus der DE 36 36 871 C2 ist eine Kolbenzylindereinheit bekannt, die einen Stellungsgeber aufweist. Der Stellungsgeber signalisiert zumindest eine vorbestimmte Lage des Kolbens relativ zu dem Zylinder. Es ist weiterhin ein induktiver Näherungsschalter in Verbindung mit einer chrombeschichteten Kolbenstange vorgesehen, wobei die Beschichtung der Kolbenstange an einer vorbestimmten Stelle eine ringförmige Einschnürung aufweist, die mit Hilfe der Bedämpfung des Näherungsschalters selektierbar ist. Bei dieser Lösung werden jedoch sehr dicke Schichten zur Bedämpfung verwendet, insbesondere mit einer Dicke von 40 bis 70 µm. In dieser Schrift ist die Anwendung auf lediglich Chromschichten begrenzt, welche eingeschränkte mechanische Eigenschaften aufweisen. Sie sind weniger gut für bestimmte Anwendungsfälle geeignet als härtere und tribologisch verbesserte angepaßte Schichten. Durch das Vorsehen der ringförmigen Einschnürung tritt eine lokale topographische Veränderung der Oberfläche durch die Schichtdickenreduktion und eine damit verbundene Schwächung der Lauffläche der Kolbenstange auf.

Aus der EP 0 685 297 A1 ist ein Verfahren zur Herstellung eines Werkzeuges für Umform- und Zerspanungsvorrichtungen sowie das Werkzeug selbst und die Zerspanungsvorrichtung bekannt. Das Werkzeug weist ein Substrat und einen darauf aufgebrachten, zumindest einen Temperatursensor und eine Verschleißsensoranordnung aufweisenden Schichtaufbau auf, wobei das Substrat zunächst einer lonenätzung unterzogen wird. Anschließend wird auf die direkten Verschleißflächen kontinuierlich eine Gradientenschicht durch Sputtern bei zunehmender Zufuhr eines Reaktionsgases aufgebracht, welche von einer Metallschicht in eine Isolationsschicht übergeht. Danach wird zumindest eine leitende Sensorschicht durch Sputtern aufgebracht und anschließend strukturiert. Eine Verschleißschutzschicht wird ebenfalls durch Sputtern abgeschieden, wobei alle Schichten unter gleichzeitigem gesteuerten Ionenbeschuß aufwachsen. Die Sensoren sind an der direkten Verschleißfläche des Werkzeuges vorgesehen und die Schichtanordnung ist ein geschlossener Schichtaufbau, welcher eine in die Oberfläche des Substrates implantierte aufgewachsene erste Gradientenschicht aufweist sowie zumindest eine leitende, die Sensoren bildende strukturierte Metallschicht und eine Verschleißschutzschicht. Die leitende, die Sensoren bildende strukturierte Metallschicht ist dabei beispielsweise als zweite Gradientenschicht ausgebildet, die kontinuierlich von der Isolationsschicht der ersten Gradientenschicht in eine Metallschicht übergeht. Die Verschleißschutzschicht kann beispielsweise die dritte Gradientenschicht sein, wobei dann eine Isolationsschicht zwischengeschaltet ist. Die erste und zweite Gradientenschicht sind beispielsweise Titan-Titanoxid und die dritte Gradientenschicht eine Titan-Titannitrid-Schicht.

Der Erfindung liegt die Aufgabe zugrunde, mechanisch beanspruchbare Komponenten oder Elemente sowie ein Verfahren zu ihrer Herstellung und eine Vorrichtung zur Durchführung des Verfahrens vorzuschlagen, durch welche die beim Stand der Technik auftretenden Nachteile vermieden werden.

Angestrebt wird außerdem, möglichst preiswerte Technik anzuwenden, so daß zusätzlich zu den mechanischen Leistungsmerkmalen auch elektrische, optische oder magnetische zustandskorrelierende Größen, die Komponente oder das Element betreffend, gewonnen werden können, ohne daß externe Sensoren oder andere zusätzliche Schichtmaterialien verwendet werden müssen.

Die Aufgabe wird gelöst durch eine Komponente oder Elemente mit
- einem Substrat
- einer darauf angeordneten isolierenden Schicht
- und mindestens einer darauf angeordneten Funktionsschicht mit sensorischen Eigenschaften,
wobei die Schichten aus amorphem Kohlenwasserstoff oder aus Bomitridsystemen bestehen,dadurch gekennzeichnet, dass die Schichten einen gemeinsamen monolithischen Aufbau bilden und dass sie sich chemisch lediglich durch eine voneinander verschiedene Dotierung mit anderen Materialien unterscheiden.

Ferner löst sie ein Verfahren zum Herstellen von derartigen mechanisch beanspruchbaren Komponenten und Elementen mit einem mit tribologischer Beschichtung zu versehendem Substrat, bei dem Komponente oder Element zumindest im Bereich des zu beschichtenden Substrates gereinigt wird, auf der gereinigten Oberfläche eine isolierende Schicht abgeschieden wird, und auf der isolierenden Schicht eine oder mehrere weitere Schichten oder ein Schichtsystem abgeschieden werden, wobei zumindest eine Funktionsschicht vorgesehen ist.

Zur Durchführung des Verfahrens eignet sich eine Vorrichtung zum Herstellen von mechanisch beanspruchbaren Komponenten oder Elementen mit einem mit tribologischer Beschichtung zu beschichtenden Substrat. Ein Magnetrontarget und eine hochfrequenzfähige, das Substrat haltende Einrichtung sind vorgesehen, wobei die Einrichtung so gestaltet ist, daß das Substrat bewegbar ist und wobei an der Einrichtung eine Spannungsquelle vorgesehen ist, die eine Biasspannung anlegt.

Unter Hochfrequenz ist hier zu verstehen, daß auch mittelfrequente und bipolare Impulstechniken angewandt werden können.

Weiterbildungen der Erfindung sind in den jeweiligen abhängigen Ansprüchen definiert.

Dadurch wird ein Verfahren sowie eine Vorrichtung und eine Komponente bzw. ein Element geschaffen, welche Anwendung auch im mikromechanischen und mikrosystemtechnischen Bereich finden. Bei der erfindungsgemäßen Kombination von ausgewählten tribologischen Schichten mit ebenfalls aus diesen Schichten realisierten und damit quasi monolithisch integrierten Zustandssensoren bzw. Zustandswandlern wird die mechanische Komponente mit einer Funktionsschicht versehen. Eine solche Funktionsschicht vergütet die Oberfläche der Komponente, beispielsweise gegen Verschleiß und Korrosion oder gibt dem Bauteil verbesserte mechanische, elektrische oder optische Eigenschaften. Aus diesem Bereich selektierte Schichten zeigen hervorragende mechanische oder passivierende Eigenschaften und zudem für eine Zustandsermittlung auswertbare elektrische, optische und/oder magnetische Wirkung. Eine Modifikation der tribologischen Schichten oder Schichtsysteme erfolgt vorzugsweise mit Mitteln der Mikrostrukturtechnik, wodurch die Funktionalität der tribologischen Schicht nicht beeinträchtigt wird.

Als tribologische Schicht eignen sich insbesondere diamantartige, amorphe Kohlenwasserstoffschichten, welche durch den Einbau von Fremdelementen so modifiziert werden können, daß neuartige Wandlerfunktionen mit dieser Schicht realisierbar sind. Eine solche Schicht weist gute tribologische Eigenschaften auf, die sich beispielsweise durch einen geringen Reibungskoeffizienten und einen sehr geringen abrasiven und adhäsiven Verschleiß bemerkbar machen.

Alternativ ist eine Konzeption mit einem Bornitridschichtsystem einsetzbar, das ähnliche Eigenschaften wie amorphe Kohlenwasserstoffschichten besitzt. Falls weitere derartige Systeme mit diesen Eigenschaften existieren, wären auch diese geeignet.

Die hervorragenden tribologischen Eigenschaften der amorphen Kohlenwasserstoffschichten sind bekannt. Von E. Cambril et al., Laser Writing on goldcontaining hydrocarbon film, in: J. Phys. D: Appl Phys 26 (1993), 149-153 ist festgestellt worden, daß eine Golddotierung derartiger Schichten und anschließende Beaufschlagung mit Laser möglich ist und dadurch die Eigenschaften der Schicht geändert werden.

Erfindungsgemäß wird nun erstmals ein technischer Einsatz von dotierten und/oder physikalisch beeinflußten Kohlenwasserstoffschichten vorgeschlagen.

Es stellte sich bei Versuchen nämlich überraschend heraus, daß sich die Eigenschaften, insbesondere die elektrischen Leitfähigkeitseigenschaften sogar sehr gezielt modifizieren lassen. Während amorphe, undotierte oder mit Fluor dotierte Kohlenwasserstoffschichten hochisolierend sind, führt eine Dotierung mit bestimmten Fremdelementen zu elektrischer Leitfähigkeit und eine gezielte Laserbeeinflussung gerade der dotierten Schicht kann zur Erzeugung von Strukturen genutzt werden.

Diese Strukturen werden nun ihrerseits erfindungsgemäß zu Sensoren ausgebildet, die über ebenso strukturierte Leiterbahnen aus der Schicht heraus zur Auswertung geführt werden.

Chemisch und mechanisch sind isolierende Schicht und leitfähige bzw. Funktionsschicht aber äußerst ähnlich, so daß mechanisch ein hervorragender Zusammenhalt entsteht, quasi ein monolithischer Aufbau des Gesamtsystems.

Eine erfindungsgemäß gestaltete Komponente oder ein Element mit integriertem Zustandswandler kann in den verschiedensten technischen Gebieten angewandt werden, beispielsweise im Maschinen- und Anlagenbau, der Medizintechnik sowie dem Gerätebau, der Mikromechanik und der Mikrosystemtechnik. Dabei ist allen Anwendungsgebieten und Verfahrensbeschreibungen gemeinsam, daß der Zustandswandler Teil des Funktionsschichtsystems ist, welches durch eine jeweilige Kombination von Verfahrensschritten in entsprechend angepaßter Weise modifiziert wird.

Es entsteht im Grunde eine "Maschine mit Haut": Die monolithische Schichtfolge ähnelt der menschlichen Haut nicht biologisch, aber funktionell in ihrer Eigenschaft als Schutz einerseits (tribologische Funktion) und als Fühler andererseits (sensorielle Funktion).

Vorteilhaft wird die mechanische Komponente oder das Element lediglich bei Anwendung von nur einem Arbeitsverfahren beschichtet.

Vorzugsweise besteht das Schichtsystem als Dünnschichtsystem in einer Ausführungsform aus einer Kohlenwasserstoffschichtfolge, wobei die Kohlenwasserstoffschichten als amorphe Hartstoffschichten mit variierbaren Eigenschaften durch ein CVD-Verfahren (chemical vapor deposition) oder ein PVD-Verfahren (physical vapor deposition) auf dem Substrat der Komponente oder des Elementes aufgebracht werden. Zu diesem Zweck wird zunächst mit bekannten Reinigungsmethoden die Oberfläche des Substrates gereinigt, auf dieser eine amorphe Kohlenwasserstoffschicht mittels eines plasmaunterstützten CVD-Prozesses abgeschieden, wobei die dazu verwendete Anlage insbesondere aus einer PVD-Anlage mit einem Magnetrontarget und einem hochfrequenzfähigen Substrathalter besteht. Vorzugsweise ist der Substrathalter so gestaltet, daß die Komponente in Mehrfachrotation während der Beschichtung bewegt wird. Die Biasspannung am Substrathalter ist bevorzugt eine mittel- oder hochfrequente Spannung und/oder bipolare Pulsspannung. Insbesondere kann sie mit einer Frequenz von 13,56 MHz betrieben werden, wobei eine Mehrzahl von Komponenten vorzugsweise in ein einziges Werkzeug eingebaut und gleichzeitig, d.h. in einem Batch, beschichtet wird. Alternativ hierzu kann die Beschichtung auch mit Hilfe einer Durchlaufanlage erfolgen.

Besonders bevorzugt erfolgt die Beschichtung dadurch, daß mittels eines Argon-Plasmas die Oberfläche des Substrates durch lonenbeschuß gereinigt wird und mit der Zugabe von einem kohlenwasserstoffhaltigen Gas, insbesondere Ethin (C₂H₂), die Kohlenwasserstoffschicht aufgebracht wird. Die Dicke der Schicht liegt insbesondere im Bereich von 0,1 µm bis 10 µm. Sie kann als Einzelschicht oder Mehrfachschicht mit unterbrochener Prozeßführung vorgesehen sein. Die auf diese Weise hergestellte amorphe Kohlenwasserstoffschicht ist elektrisch isolierend und weist beispielsweise einen spezifischen Widerstand von sehr viel mehr als 10⁶ Ohm cm auf.

Vorzugsweise folgt auf die isolierende Schicht die Abscheidung einer Schichtenfolge aus beispielsweise einer metalldotierten amorphen Kohlenwasserstoffschicht durch lediglich Hinzuschalten des Magnetrons. Das Magnetrontarget stellt dabei dann die Metallquelle dar. Besonders bevorzugt werden Titan- und Wolfram-Kohlenstoffhaltige amorphe Kohlenwasserstoffschichten angewendet, deren elektrische Eigenschaften über den Titangehalt in der Schicht in weiten Grenzen einstellbar sind. Dabei werden vorteilhaft die hervorragenden tribologischen Eigenschaften dieser Schicht beibehalten. Besonders bevorzugt werden gradierte Übergänge zwischen der isolierenden Schicht und der metallhaltigen Schicht eingestellt. Die metallhaltige amorphe Kohlenwasserschicht kann dabei elektrisch so gestaltet werden, daß der Widerstandswert der gewünschten sensorischen Anwendung anpassbar ist. Eine solche Anpassung kann über die Art der verwendeten Metalle und deren Konzentration erfolgen. Vorzugsweise werden die metallhaltigen elektrisch leitenden Schichten im Dickenbereich von 50 nm bis 10 µm angewendet.

Besonders bevorzugt erfolgt eine Strukturierung der metallhaltigen amorphen Kohlenwasserstoffschicht mittels einer Laserbestrahlung. Vorzugsweise wird ein geeigneter Laserstrahl mit einem geringen Fokusdurchmesser von insbesondere 1 bis 500 µm, abhängig von den zu bildenden Strukturen, über die beschichtete Oberfläche geführt. Leistung, Pulsdauer, Frequenz und Wellenlänge der Strahlung des Lasers werden dabei optimiert.

Die Strukturierung kann durch geeignete Wahl der Laserbestrahlung und der Nachbehandlung so genutzt werden, daß ähnlich wie bei lithographischen Verfahren bestimmte Teile der metallhaltigen amorphen Kohlenwasserstoffschicht, nicht aber der darunterliegenden isolierenden Schicht, entfernt werden. Bevorzugt aber bleibt es bei der Umwandlung der elektrischen Eigenschaften und Stehenlassen aller Teile.

Dieser Effekt der Wandlung der elektrischen Eigenschaften wird mittels der unterschiedlichen Elementabsorption erzielt. Dabei werden die Laserwellenlänge sowie die in der Kohlenwasserstoffmatrix enthaltenen Metalle oder Metallcarbide in optimaler Weise so angepaßt, daß eine selektive Modifikation der metallhaltigen Kohlenwasserstoffschicht erfolgen kann. Bei einigen Anwendungsfällen bzw. Ausführungsformen der Komponenten oder Elemente wird eine verschleißfeste und reibungsarme metallartige amorphe Kohlenwasserstoffschicht als ideale Funktionsbeschichtung gewünscht. In diesen Fällen kann von einer weiteren Beschichtung abgesehen werden.

Anstelle der metallhaltigen amorphen Kohlenwasserstoffschicht kann auch eine geeignete andere Schicht oder ein Schichtsystem aufgebracht werden. Insbesondere weisen Titannitridschichten ebenfalls elektrische Eigenschaften auf, die für eine thermoresistive Auswertung geeignet sind. Zu diesen Schichten zählen auch solche aus einer Kombination aus Titan, Sauerstoff, Stickstoff, Kohlenstoff.

Besonders bevorzugt wird das Substrat der Komponente oder des Elementes mit einer elektrisch isolierenden amorphen Kohlenwasserstoffschicht beschichtet. Anschließend wird mittels eines Laserstrahles diese Schicht an der Oberfläche karbonisiert und dadurch in vorbestimmten Spuren elektrisch leitfähig gemacht.

Vorzugsweise wird das Substrat mit einer elektrisch isolierenden Funktionsschicht bedeckt. Dabei kann ein Schichtsystem aus isolierenden amorphen Kohlenwasserstoffschichten, welche Zusätze von Fluor enthalten, vorgesehen sein, wodurch diese hinsichtlich ihrer Oberflächenenergie beeinflußbar sind.

Alternativ kann auch eine elektrisch leitende Schicht als Funktionsschicht verwendet werden, welche auf einer strukturierten Sensor- bzw. Leiterbahnebene aufgebracht wird. Dabei wird eine isolierende Zwischenschicht aus einer amorphen Kohlenwasserstoffschicht vorzugsweise zwischen der elektrisch leitenden Schicht und der Sensor- bzw. Leiterbahnebene vorgesehen.

Vorzugsweise kann auch ein Schichtsystem mit isolierenden Titandioxidschichten in Kombination mit gradierten Titan-Stickstoff-Sauerstoff- und Titan-Stickstoff-Kohlenstoff-Schichtsystem verwendet werden. Besonders bevorzugt werden Titan-Bor-Stickstoff- und Bornitridschichtsysteme verwendet. Die elektrische Leitfähigkeit von Bornitridschichten kann vorteilhaft um einige Größenordnungen durch Zugabe von Titan variiert werden. Besonders bevorzugt wird das Substrat der Komponente zunächst mit einer titanhaltigen gradierten Bornitridschicht durch ein PVD-Verfahren beschichtet. Als Magnetrontarget dient dabei ein borhaltiges Material, insbesondere Bornitrid oder B₄C. Die Schichtabscheidung erfolgt vorzugsweise bei ca. 150 bis 250 V Biasspannung am Substrat, wobei das Magnetrontarget mit einer Leistung von 5 W/cm² gefahren wird. Vorzugsweise werden etwa 20 % Stickstoff zum Sputtergas Argon hinzugegeben. Die Stromdichte am Substrat beträgt vorzugsweise 1 bis 3 mA/cm². Dadurch werden Bornitridschichten mit kubischer Phase hergestellt, auf die in einem Vakuumprozeß eine elektrisch leitende Sensorschicht aus beispielsweise Titan-Bor-Stickstoff aufgebracht wird. Eine Strukturierung der Schicht kann beispielsweise unter Zuhilfenahme von Lasertechniken erfolgen. Besonders bevorzugt wird auf die so erzeugten Strukturen eine weitere elektrisch isolierende Schicht aus kubischem Bornitrid aufgebracht, welche eine hohe Härte und sehr geringe Gleitreibung aufweist.

Eine Auskoppelung von Signalen kann beispielsweise über Leiterbahnen und entsprechende Kontakte erfolgen. Zudem können erfindungsgemäß auch telemetrische Übertragungen realisiert werden, wie beispielsweise induktive, indem z.B. ein thermoresistiver Sensor zur Temperaturmessung über die Leiterbahnen mit einer aus wenigen Windungen bestehenden Spule verbunden wird. Vorteilhaft wird dabei mittels Durchkontaktierungen auch das Substrat der mechanischen Komponente oder des Elementes als Teil der Stromführung genutzt. Die entsprechend auftretenden Signale können dadurch mit einer entsprechenden Kopplungsspule ausgelesen werden. Dabei können auch kapazitive Kopplungen realisiert werden. Eine Verschleißmessung kann beispielsweise durch sequentiell angeordnete, leitfähige, strukturierte Bereiche oder durch kontinuierlich über den Verschleiß erfolgende Widerstandsänderungen realisiert werden.

Zur näheren Erläuterung der Erfindung werden im folgenden Ausführungsbeispiele anhand der Zeichnungen beschrieben.

Diese zeigen in:
- **Figur 1**: eine prinzipielle Schnittansicht einer ersten Ausführungsform einer erfindungsgemäßen mechanischen Komponente,
- **Figur 2**: eine prinzipielle Schnittansicht einer zweiten Ausführungsform einer erfindungsgemäßen mechanischen Komponente,
- **Figur 3**: eine prinzipielle Schnittansicht einer dritten Ausführungsform einer erfindungsgemäßen mechanischen Komponente,
- **Figur 4**: eine seitliche Schnittansicht als Prinzipskizze eines erfindungsgemäß ausgestalteten Pneumatikzylinders,
- **Figur 5**: eine Querschnittsansicht durch eine tribologische Funktionsschicht,
- **Figur 6**: eine Seitenansicht einer weiteren Ausführungsform einer erfindungsgemäßen mechanischen Komponente,
- **Figur 7**: eine Prinzipskizze eines erfindungsgemäß gestalteten Gleitlagers,
- **Figur 8**: eine Draufsicht auf eine erfindungsgemäß ausgestaltete Wendeschneidplatte mit Zustandswandler,
- **Figur 9**: eine Seitenansicht mit vergrößertem Detailausschnitt einer erfindungsgemäß beschichteten Nähmaschinennadel und
- **Figur 10**: eine Seitenansicht mit vergrößerter Detailansicht einer weiteren Ausführungsform einer erfindungsgemäß gestalteten Nähmaschinennadel.

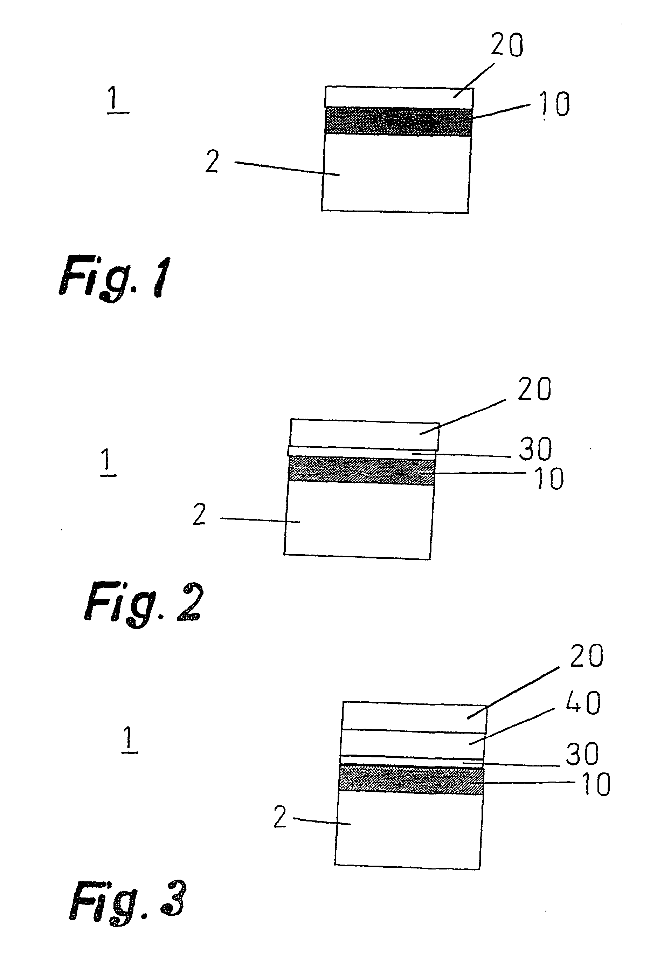

In **Figur 1** ist eine prinzipielle Schnittansicht einer ersten Ausführungsform einer erfindungsgemäßen mechanischen Komponente 1 dargestellt. Die mechanische Komponente 1 weist ein Substrat 2 auf. Dieses ist zunächst mit einer isolierenden Schicht 10 und darüber mit einer Funktionsschicht 20 beschichtet. Die Funktionsschicht kann beispielsweise eine mit Sensoren und Leiterbahnen versehene Schicht oder ein Schichtensystem sein.

Beispielsweise wird zunächst die Substratoberfläche gereinigt und anschließend auf der gereinigten Oberfläche die isolierende Schicht 10 in Form einer amorphen Kohlenwasserstoffschicht abgeschieden. Hierzu wird vorzugsweise ein CVD- oder ein PVD-Verfahren angewendet. Der CVD-Prozeß kann beispielsweise Hochfrequenzplasma unterstützt sein. Zur Durchführung dieses Verfahrens wird beispielsweise eine PVD-Anlage verwendet. Diese weist ein Magnetrontarget und einen hochfrequenzfähigen Substrathalter auf. In den Substrathalter wird das Substrat der mechanischen Komponente eingebracht bzw. an diesem befestigt. Während der Beschichtung wird der Substrathalter mit dem darin befestigten Substrat in Mehrfachrotation bewegt. An dem Substrathalter wird eine Biasspannung in Form einer mittel- oder hochfrequenten Spannung oder aber eine bipolare Pulsspannung angelegt. Beispielsweise wird die PVD-Anlage mit einer Frequenz von 13,56 MHz betrieben.

Während der Beschichtung kann eine Mehrzahl von mechanischen Komponenten oder Elementen gleichzeitig beschichtet werden, was als Batchbetrieb bezeichnet wird. Alternativ hierzu kann aber auch eine Beschichtung mittels einer Durchlaufanlage vorgesehen werden, in der die einzelnen mechanischen Komponenten nacheinander, also sequentiell, beschichtet werden.

Die Beschichtung kann beispielsweise alternativ auch dahingehend erfolgen, daß eine elektrisch isolierende Funktionsschicht 20 als oberste Schicht mit einer darunter vorgesehenen sensorischen Schicht 30 und einer darunter vorgesehenen isolierenden Schicht 10 auf dem Substrat angeordnet werden. Eine solche Ausführungsvariante ist als prinzipielle Schnittansicht in **Figur 2** dargestellt. Besonders geeignet sind für diese Ausführungsform Schichtsysteme aus isolierenden amorphen Kohlenwasserstoffschichten, die Zusätze von Fluor enthalten und die auf einfache Weise hinsichtlich ihrer Oberflächenenergie beeinflußbar sind.

In einer dritten Ausführungsform kann auch eine elektrisch leitende Schicht in Form einer Funktionsschicht 20 oberhalb einer strukturierten sensorischen oder Leiterbahnschicht 30 angeordnet sein. Zwischen der Funktionsschicht 20 und der sensorischen Schicht 30 ist dabei eine isolierende Zwischenschicht 40 aus einem amorphen Kohlenwasserstoff vorgesehen.

Alternativ zu den beschriebenen Schichtsystemen können auch isolierende Titandioxidschichten in Kombination mit gradierten Titan-Stickstoff-Sauerstoff- und Titan-Stickstoff-Kohlenstoff-Schichtsystemen verwendet werden. Als besonders vorteilhaft erweist sich die Verwendung von Schichtsystemen aus Titan-Bor-Stickstoff bzw. Bornitrid. Die elektrische Leitfähigkeit von Bornitridschichten ist nämlich um mehrere Größenordnungen durch Zugabe von Titan variierbar. Beispielsweise kann das Substrat 2 zunächst mit einer titanhaltigen gradierten Bornitridschicht beschichtet werden. Hierzu wird vorzugsweise ein PVD-Verfahren verwendet. Als Magnetrontarget dient dabei vorzugsweise ein borhaltiges Material, beispielsweise Bornitrid oder B₄C (Borcarbid). Die Schichtabscheidung erfolgt dabei beispielsweise bei einer Spannung von 150 bis 250 V als Biasspannung am Substrat 2, wobei das Magnetrontarget mit einer Leistung von etwa 5 W/cm² gefahren wird. Dabei werden etwa 20 % Stickstoff zum Sputtergas Argon hinzugegeben. Die Stromdichte am Substrat 2 beträgt dann ca. 1 bis 3 mA/cm². Dadurch werden die Bornitridschichten in kubischer Phase hergestellt, auf welche in einem Vakuumprozeß die elektrisch leitende sensorische Schicht 30 aus beispielsweise einer Verbindung aus Titan/Bor/Stickstoff aufgebracht wird. Vorzugsweise mittels Lasertechnik wird diese sensorische Schicht anschließend strukturiert.

Auf die so erzeugten Strukturen wird die elektrisch isolierende Schicht 40 aus kubischem Bornitrid aufgebracht, welche eine hohe Härte und sehr geringe Gleitreibung aufweist.

Eine Auskopplung der Signale erfolgt vorzugsweise über Leiterbahnen und entsprechende Kontaktflächen. Dies geht besser aus den folgenden Figuren hervor.

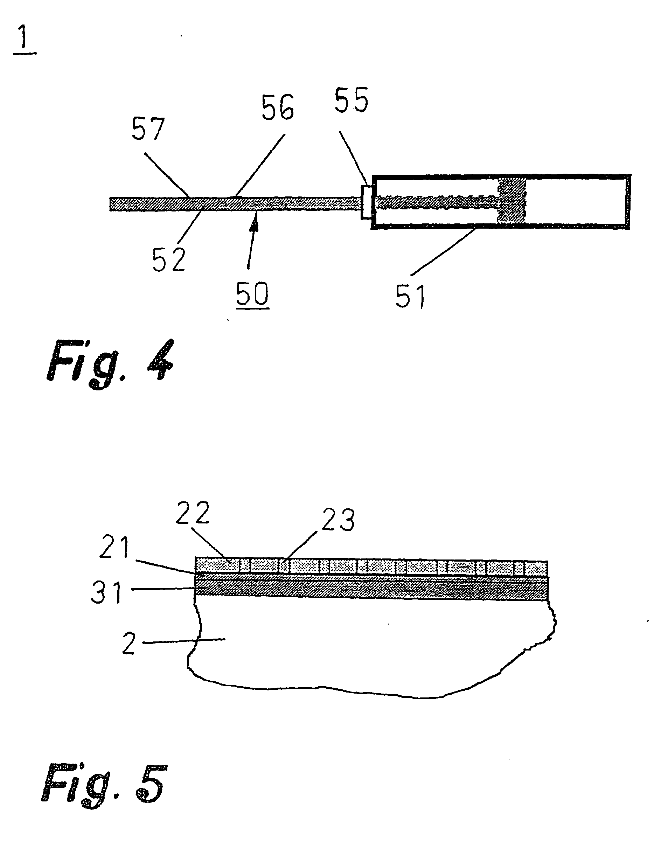

**Figur 4** zeigt eine seitliche Schnittansicht als Prinzipskizze eines Pneumatikzylinders als mechanisches Element. Der Pneumatikzylinder weist einen Kolben 50 und einen Kolbenzylinder 51 auf. Der Kolben selbst weist eine Kolbenstange 52 auf. Zum Vermindern von Reibung und Verschleiß ist es wünschenswert, die mobilen Komponenten, also Kolben mit Kolbenstange mit einer optimierten Vergütungsschicht zu versehen. Hierzu eignet sich eine amorphe diamantartige Kohlenwasserstoffschicht, die als isolierende Hartstoffschicht, also ohne Metallzusätze, oder als metallhaltige bzw. metallcarbidhaltige Schicht bekannt ist. Diese Schichten werden erfindungsgemäß so modifiziert, daß die gewünschten funktionalen Eigenschaften erhalten bleiben, zusätzlich jedoch auch sensorische oder aktorische Funktionen verwirklicht werden können.

Der Kolben 50 mit Kolbenstange 52 wird daher mit einer amorphen metallhaltigen Kohlenwasserstoffschicht beschichtet, durch ein PVD-Verfahren, beispielsweise einen ionenunterstützten Magnetronsputterprozeß. Wie bereits erwähnt, kann die Beschichtung im Batchbetrieb erfolgen, in einer Großanlage mit beispielsweise vier Kathodenstationen. Der Substrathalter rotiert darin beispielsweise zwei- bis dreifach die in ihm montierten Kolbenstangen.

Die Herstellung der amorphen metallhaltigen Kohlenwasserstoffschicht erfolgt in mehreren Schritten, wobei zunächst eine lonenätzung der Substratoberfläche vorgesehen ist, worauf eine Haftschicht auf die Oberfläche aufgebracht wird. Unter Beibehalten der gesamten Verfahrensbedingungen, lediglich durch Umschalten der Sputtergase auf beispielsweise Ethin (C₂H₂) wird mittels einer Gradientenschicht der optimale Metallgehalt eingestellt und beispielsweise eine Schichtdicke von 0,1 bis 10 µm erzeugt. Als Metall kann ein ferromagnetisches Material oder ferromagnetische Verbindungen verwendet werden, wobei die Konzentration des Metalles im Bereich von 2 % bis 50 % liegen kann.

Überraschenderweise hat sich gezeigt, daß die magnetischen Eigenschaften mittels Laserstrahlung beeinflußt werden können. Bei geeigneter Anordnung von lokal laserbehandelten Markierungen kann daher ein hochgenaues Wegmeßsystem unter Zuhilfenahme eines Magnetkopfes erzeugt werden. Die Art der verwendeten Elemente und die aufgebrachte Laserleistung bestimmen dann die Änderung der magnetischen Eigenschaften der laserbestrahlten Bereiche. Die Laserwellenlänge wird dabei so ausgewählt, daß eine hohe Absorption für das Metall vorliegt. Bei entsprechender Fokussierung der Laserstrahlung können hochaufgelöste Markierungen in der tribologischen Funktionsschicht 20 erzeugt werden, die mittels eines geeigneten Magnetkopfes oder einer mikrotechnisch hergestellten Induktionsspule ausgewiesen werden können. Ein solcher induktiver Sensor 56 ist in Figur 4 lediglich angedeutet.

Die Wegmessung kann beispielsweise auch optisch erfolgen, wobei dann ein optischer Sensor 55 an dem Pneumatikzylinder vorgesehen ist. Eine optische Veränderung der von Laserlicht bestrahlten Schichtbereiche von amorphen Kohlenwasserstoffschichten mit und ohne Metalldotierung kann durch entsprechende Wahl der Laserleistungsdichte geschaffen werden. Beispielsweise können in einer wolframdotierten metallhaltigen Kohlenwasserstoffschicht ein oder mehrere Markierungen angebracht werden, welche optisch durch Reflexion detektierbar sind. Werden diese Markierungen entsprechend auf der Kolbenstange angebracht, können damit hochgenaue Weg- oder Positionsmeßsysteme realisiert werden.

Eine solche Ausführungsform mit Metalldotierungen bzw. dotierten Bereichen 22 in einer amorphen Kohlenwasserstoffschicht 21 auf einem Wegsensor 31 zeigt im Detailausschnitt die **Figur 5**. Die einzelnen Metalldotierungen 23 sind dabei angedeutet. Die dargestellte tribologische Funktionsschicht kann aus einer diamantartigen amorphen Kohlenwasserstoffschicht bestehen, deren oberer Bereich, wie beschrieben, mit Metall oder Metallcarbiden dotiert wird. Der Wegsensor 31 ist beispielsweise eine Struktur, die lokal durch einen Laser umgewandelt wurde und eine metallhaltige reibungsarme Verschleißschutzschicht 57, wie sie auch Figur 4 in Andeutung entnommen werden kann, ist.

In einer alternativen Ausführungsform können die elektrischen Eigenschaften von amorphen Kohlenwasserstoffschichten genutzt werden, um eine potentiometrische Wegmessung zu realisieren. Hierfür wird unter Variation der Beschichtungsbedingungen zunächst eine metallarme oder metallfreie amorphe Kohlenwasserstoffschicht auf die Kolbenstange aufgebracht. Diese erste Schicht ist elektrisch isolierend mit einem Widerstand von etwa 10⁶ bis 10¹² Ohm cm. Durch Ändern der Beschichtungsbedingungen wird auf diese Schicht unter Beibehalten des Vakuums eine metallhaltige Kohlenwasserstoffschicht abgeschieden, beispielsweise eine wolframhaltige mit 5 bis 45 % Wolfram. Diese wolframhaltige Metallschicht wird mit der leitfähigen Kolbenstange verbunden und mittels elektrischer Schleifkontakte als Wegmesser verwendet. Auf der Kolbenstange können definierte Widerstandsbahnen durch Laserschnitte oder fotolithographische Verfahren erzeugt werden. In einem solchen Fall kann eine Auskopplung der Signale bei geeigneter Formgebung der Widerstandsbahnen auch telemetrisch erfolgen, also induktiv oder kapazitiv.

Zusätzlich kann die Kolbenstange auch mit weiteren Zustandssensoren zur Erweiterung der Wegmessung ausgestattet werden. Die metallhaltige tribologische Schicht wird durch Laser so strukturiert, daß die thermoresistiven Eigenschaften der Schicht in Form eines Widerstandes und einer daran angeschlossenen spurenförmigen Leiterbahnführung zu einem thermoresistiven Sensor mit induktiver Signalauskopplung verwendet werden.

Bei entsprechender Materialwahl, beispielsweise bei geeigneter Metalldotierung der amorphen Kohlenwasserstoffschicht 21, können zudem auch Kraft- oder Torsions- bzw. Drehmomentenmessungen durchgeführt werden.

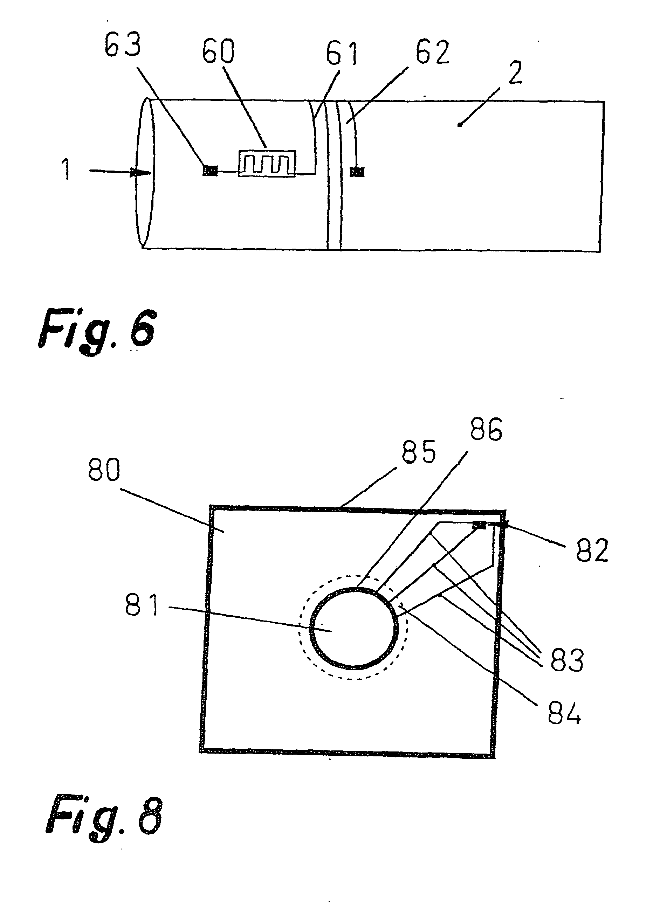

**Figur 6** zeigt eine weitere Ausführungsform einer erfindungsgemäß gestalteten mechanischen Komponente 1 in Form von Laufflächen eines Liniearantriebs mit Führungsschlitten. Die Laufflächen werden dabei zunächst mit einer reibungsarmen Schicht versehen. Hierzu eignet sich besonders eine amorphe Kohlenwasserstoffschicht, welche beispielsweise in Kombination mit einer metallhaltigen Kohlenwasserstoffschicht eine Isolation zwischen dem metallischen Schlitten und der tribologischen Funktionsschicht bewirkt.

Die in Figur 6 dargestellten Leiterbahnen 61 in Form zum einen einer induktiven Signalauskopplung 62 sowie in Form eines thermoresistiven Sensors 60 und in Form von Kontaktflächen 63 werden durch lokale Laserstrukturierung in der metallhaltigen Kohlenwasserstoffschicht erzeugt. Dabei entstehen außer einem Thermosensor beispielsweise auch Positions- und Kraft- bzw. Drucksensoren. Eine telemetrische Auskopplung der Meßsignale kann nur alternativ zu der induktiven Signalauskopplung 62, auch kapazitiv realisiert werden.

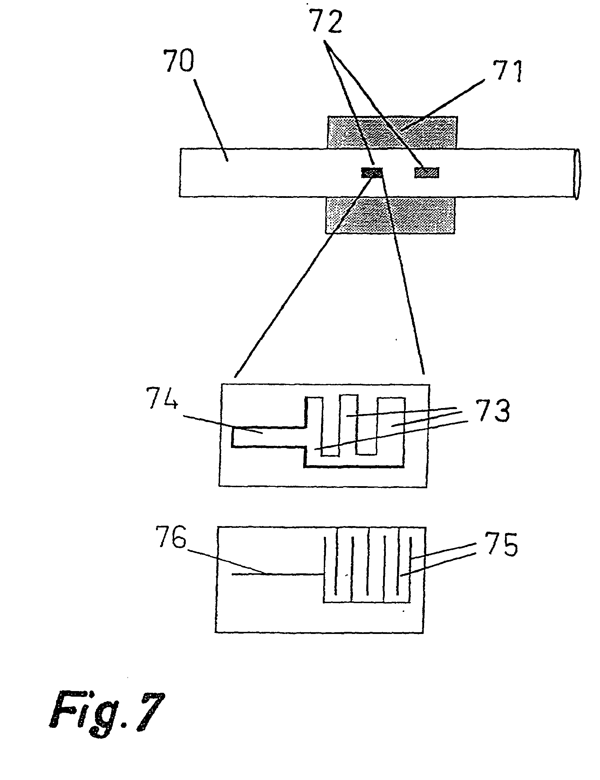

In **Figur 7** ist eine Prinzipskizze eines erfindungsgemäß gestalteten Gleitlagers dargestellt, welches eine Längsachse 70 sowie eine Lagerschale 71 aufweist. Im Bereich der Lagerschale sind Zustandssensoren 72 angeordnet. Die Zustandssensoren können beispielsweise thermoresistive Sensoren sein, wie sie prinzipiell in vergrößerter Darstellung zum einen durch senkrechte Streifenelemente 73 und ein waagerecht angeordnetes Streifenelement 74 dargestellt sind. Zum anderen ist darunter eine Vergrößerung der Realisierung eines solchen Sensors mit Laserschnitten 75, 76 angedeutet.

Ein Gleitlager ist eine rotierende mechanische Komponente, bei der sowohl die Gleiteigenschaften des Lagers als auch die Standzeit zu verbessern sind. Dabei ist es auch wichtig, Zustandsinformationen für die Hauptbelastungszone des Lagers online zu erhalten. Zu diesem Zweck wird die Achse 70 mit einer amorphen Kohlenwasserstoffschicht beschichtet, auf welche im weiteren Prozeßverlauf durch Änderung der Beschichtungsparameter eine metallhaltige amorphe Kohlenwasserstoffschicht aufgebracht wird. Die erste amorphe Kohlenwasserstoffschicht wird beispielsweise in einem Dickenbereich von 0,1 bis 15 µm aufgebracht, wohingegen die metallhaltige amorphe Kohlenwasserstoffschicht eine an die sensorische Funktion dieser Schicht angepaßte Dicke aufweist. Dabei sind die Dicke der metallhaltigen amorphen Kohlenwasserstoffschicht sowie die Metalldotierung auf den jeweiligen Anwendungsfall optimal angepaßt. Die erforderlichen oder gewünschten Zustandswandler, wie beispielsweise Temperaturaufnehmer, werden durch eine selektive Laserstrukturierung erzeugt. Die telemetrische Signalauskopplung, also induktive oder kapazitive Signalauskopplung, wird vorbereitet, indem zumindest eine Leiterschleife erzeugt wird, welche mit einem in der Lagerschale 71 an vorbestimmter Stelle angebrachten induktiven Wandler zur Übertragung der Signale zusammenwirkt.

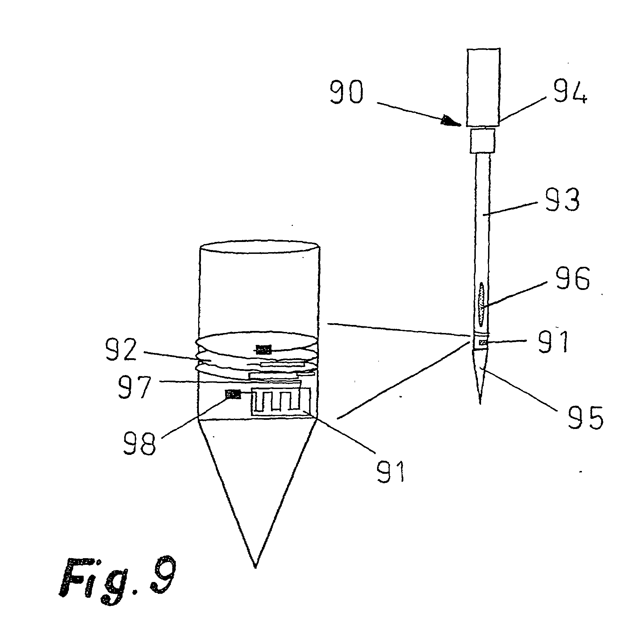

In **Figur 8** ist eine Draufsicht auf eine erfindungsgemäß ausgestaltete Wendeschneidplatte 80 mit Zustandswandler 82 dargestellt. Die Wendeschneidplatte weist eine zentrale Öffnung 81 auf. Diese ist von einer Kontaktfläche 84 umgeben. Im Kantenbereich 85 der Wendeschneidplatte ist der Zustandswandler 82 angeordnet. Dieser ist über Leiterbahnen 83 mit dem Rand 86 im Bereich der Kontaktflächen der zentralen Öffnung 81 verbunden. Zustandswandler kann beispielsweise ein thermoresistiver Sensor oder aber ein Verschleißsensor sein. Gerade im Eckenbereich einer Wendeschneidplatte ist auch die Überwachung der abgetragenen Kante bzw. des Verschleißes sehr wichtig. Die Wendeschneidplatte wird bekanntlich für die Zerspanung verwendet. Es ist jedoch bei Verschleiß im Kantenbereich bzw. im Bereich der Ecken der Wendeschneidplatte keine reproduzierbare Zerspanung eines Werkstückes mehr möglich.

Die Wendeschneidplatte als mechanisches Element wird auf ihrem Substrat mit einem auf Bornitrid basierenden Schichtsystem versehen. Dieses kann in einer PVD-Anlage aufgebracht werden. Dabei wird zunächst eine titanreiche Bornitridhaftschicht aufgebracht und anschließend eine gradierte und darauf eine reine Bornitridschicht aufgebracht. Die Parameter des PVD-Verfahrens werden so eingestellt, daß die Schicht in kubischer Phase aufwächst. Die Schichtdicke liegt dann im Bereich von 0,5 bis 10 µm. Während des laufenden Prozesses also ohne Unterbrechung des Prozesses (kontinuierlich) wird ein titanhaltiges Magnetrontarget hinzugeschaltet, wodurch eine titandotierte Bomitridschicht aufwächst, welche ebenfalls in kubischer Phase vorgesehen ist. Leitfähigkeit und Dicke der Schicht werden auf den zu erzeugenden Zustandswandler 82 abgestimmt.

Alternativ können auch andere verschleiß- und reibungsmindernde Hartschichtsysteme verwendet werden. Beispielsweise sind auch diamantbasierende Schichten mit auf den jeweiligen Anwendungsfall abgestimmter Dotierung besonders gut geeignet.

**Figur 9** zeigt eine Seitenansicht mit vergrößertem Detailausschnitt einer erfindungsgemäß beschichteten Nähmaschinennadel 90. Die Nähmaschinennadel 90 weist einen Nadelkolben 93 mit Langloch 96 zum Durchfädeln eines Fadens auf. Die Nadel endet mit einer Spitze 95. Mittels des auf der entgegengesetzten Seite des Nadelkolbens angeordneten Einspannelementes 94 kann die Nähmaschinennadel in einer Nähmaschine befestigt werden.

Zwischen Langloch 96 und Spitze 95 ist auf dem Nadelkolben 93 ein Temperatursensor 91 mit Induktionsspule 92 angeordnet. Dies ist besser der Detailansicht zu entnehmen. Durch eine größere Kontaktfläche 98, welche über eine Leiterbahn 97 mit dem Temperatursensor 91 verbunden ist, wird eine gute Verbindung zu der Oberfläche der Nähmaschinennadel geschaffen. Die Leiterbahn 97 führt in eine Induktionsspule 92, welche den gesamten Umfang des Nadelkolbens umgibt. Die Induktionsspule 92 endet ebenfalls in einer Kontaktfläche 98. Auch hierdurch wird wieder ein guter Kontakt zu der Oberfläche des Nadelkolbens 93 geschaffen.

Da Nähmaschinennadeln zum Nähen unterschiedlicher Materialien und Materialdicken eingesetzt werden, sollte bei allen Nähvorgängen das Nähgut fehlerfrei durchstochen werden. Dieser Vorgang wird, abhängig von der jeweiligen Anwendung, mehrere 1000mal in der Minute durchgeführt. Deshalb sollte für die jeweilige Anwendung die Nadelgestaltung optimiert werden. Ebenso sind die Gleiteigenschaften zwischen der Nadeloberfläche und dem Nähgut von besonderer Wichtigkeit. Bei großen Reibungswerten wird nämlich die Nadel erheblich mechanisch und thermisch beansprucht. Daher erweist es sich gerade bei modernen Hochleistungsnähmaschinen als wünschenswert, den Belastungszustand der Nähnadel während des Betriebes online zu messen, um somit die Nähmaschine entsprechend der Beanspruchungsart steuern zu können. Dadurch können dann auch Rückschlüsse über den Zustand der Nadeloberfläche erhalten werden. Eine in die Hauptbelastungszonen der Nähnadel integrierte Zustandssensorik ermöglicht dabei eine intelligente Maschinensteuerung, wobei mittels eines wissensbasierten Rechnersystemes die an der Nadeloberfläche gemessenen Temperatur-, Kraft- und Verbiegungswerte zur Optimierung des Nähprozesses genutzt werden können.

Der in Figur 9 dargestellte Temperatursensor wird in Form eines Dünnschichtsystemes auf den Nadelkolben aufgebracht. Dieser Dünnschichtaufbau hält den mechanischen und thermischen Belastungen während des Nähvorganges dadurch stand, daß die sensorischen Schichten Teil des Funktionsschichtsystems sind und schichttechnologisch in das System integriert sind.

Das Dünnschichtsystem weist eine Kohlenwasserstoffschichtenfolge auf, wobei die Kohlenwasserstoffschichten als amorphe Hartstoffschicht mit variierten Eigenschaften wiederum durch das CVD- oder das PVD-Verfahren hergestellt werden. Die Beschichtung erfolgt dabei zunächst unter Zuhilfenahme eines Argon-Plasmas, durch welches durch lonenbeschuß die Nadeloberfläche gereinigt wird. Anschließend wird unter Zugabe von beispielsweise Ethin die Kohlenwasserstoffschicht aufgebracht. Anstelle von Ethin können auch andere kohlenwasserstoffhaltige Gase verwendet werden. Die Dicke der dabei aufgebrachten Schicht liegt zwischen 1 und 10 µm. Diese Schicht kann als Einzelschicht oder mit unterbrochener Prozeßführung (diskontinuierlich) aus Mehrfachschichten aufgebaut sein. Die dadurch hergestellte amorphe Kohlenwasserstoffschicht ist elektrisch isolierend und weist einen spezifischen Widerstand auf, der sehr viel größer als 10⁶ Ohm cm ist.

Auf diese isolierende Schicht kann eine Titan-Kohlenstoff-haltige amorphe Kohlenwasserstoffschicht aufgebracht werden, deren elektrische Eigenschaften über den Titangehalt in weiten Grenzen einstellbar sind. Dabei werden die hervorragenden tribologischen Eigenschaften beibehalten. Bei der Herstellung dieser Schicht werden gradierte Übergänge zwischen der isolierenden Schicht und der metallhaltigen Schicht eingestellt. Die metallhaltige amorphe Kohienwasserstoffschicht kann elektrisch so gestaltet werden, daß der Widerstand während der gewünschten sensorischen Anwendung angepaßt wird. Diese Anpassung erfolgt über die Art der verwendeten Metalle und deren Konzentration. Die metallhaltigen elektrisch leitenden Schichten werden vorteilhaft im Dickenbereich von 50 nm und 10 µm aufgebracht.

Eine Strukturierung der metallhaltigen amorphen Kohlenwasserstoffschicht kann wiederum durch Lasertechnik erfolgen. Hierbei ist beispielsweise ein Laserstrahl mit einem geringen Fokusdurchmesser von beispielsweise 5 bis 50 µm zur Strukturierung der beschichteten Nadeloberfläche geeignet. Um lediglich die metallhaltige amorphe Kohlenwasserstoffschicht an den gewünschten Spuren bzw. in den gewünschten Bereichen zu entfernen, werden Leistung, Pulsdauer und Frequenz, ebenso die Wellenlänge der Strahlung des Lasers entsprechend optimal eingestellt. Die unter der metallhaltigen amorphen Kohlenwasserstoffschicht vorgesehene isolierende amorphe Kohlenwasserstoffschicht bleibt dabei im wesentlichen erhalten. Dies geschieht aufgrund der unterschiedlichen Elementabsorption, wobei sowohl die Laserwellenlänge als auch die in der Kohlenwasserstoffmatrix enthaltenen Metalle oder Metallcarbide in optimaler Weise angepaßt werden. Dadurch findet eine selektive Modifikation der metallhaltigen amorphen Kohlenwasserstoffschicht statt.

Von einer weiteren Beschichtung kann in dem Fall abgesehen werden, wenn die verschleißfesten und reibungsarmen metallhaltigen amorphen Kohlenwasserstoffschichten eine ideale Funktionsbeschichtung darstellen. Anstelle der metallhaltigen amorphen Kohlenwasserstoffschicht können aber auch andere geeignete Schichten oder Schichtsysteme aufgebracht werden. Verschleißfeste Titannitridschichten weisen beispielsweise ebenfalls elektrische Eigenschaften auf, welche für die thermoresistive Auswertung geeignet sind. Andere verschleißfeste Schichten können aus einer Kombination von Titan-Sauerstoff-Stickstoff-Kohlenstoff geschaffen werden.

Die Nähnadel kann aber auch mit einer amorphen Kohlenwasserstoffschicht beschichtet werden, welche elektrisch isolierend wirkt. Zum Elektrisch-leitfähigmachen dieser Schicht an bestimmten Stellen bzw. Spuren wird ein Laser verwendet, dessen Strahl diese Schicht an der Oberfläche karbonisiert. Alternativ kann auch auf die amorphe Kohlenwasserstoffschicht eine Goldschicht von wenigen Nanometern Dicke aufgebracht werden. Anschließend findet eine Laserbestrahlung statt, welche zur Diffusion der Goldschicht in den jeweils bestrahlten Bereichen bzw. Spuren dient. Auch hierdurch läßt sich eine leitfähige Struktur erzielen, welche sowohl als Leiterbahn als auch als thermoresistiver Sensor hergestellt werden kann. Nach dieser Strukturierung wird der überschüssige Teil der Goldschicht wieder von der Oberfläche der Nadel entfernt. In einer anderen Ausführungsform kann die Oberfläche der Nähnadel mit einer elektrisch isolierenden Funktionsschicht bedeckt werden. In Abhängigkeit von den verschiedenen Nähgütern können Schichtsysteme aus isolierenden amorphen Kohlenwasserstoffschichten unter Zusatz von Fluor verwendet werden, wodurch auf einfache Weise die Oberflächenenergie der Schicht beeinflußt werden kann. Alternativ hierzu kann auch eine elektrisch leitende Schicht als Funktionsschicht auf der strukturierten sensorischen bzw. Leiterbahnschicht vorgesehen werden. Dabei wird, wie bereits in Figur 3 dargestellt, eine isolierende Zwischenschicht aus einer amorphen Kohlenwasserstoffschicht zwischen die elektrisch leitende Schicht als Funktionsschicht und die strukturierte Sensor-Leiterbahnschicht eingebracht.

Als Schichtsysteme eignen sich auch isolierende Titandioxidschichten in Kombination mit gradierten Schichtsystemen aus Titan-Stickstoff-Sauerstoff und Titan-Stickstoff-Kohlenstoff. Als besonders vorteilhaft erweist sich auch ein Schichtsystem aus Titan-Bor-Stickstoff und Bornitrid. Die Ausgestaltung erfolgt dabei mittels des Verfahrens, wie es zu Figur 3 beschrieben wurde.

Es können alternativ auch Diamantschichten als Isolator in Kombination mit geeigneten anderen Sensorschichten, welche eventuell auch dotiert sind, verwendet werden.

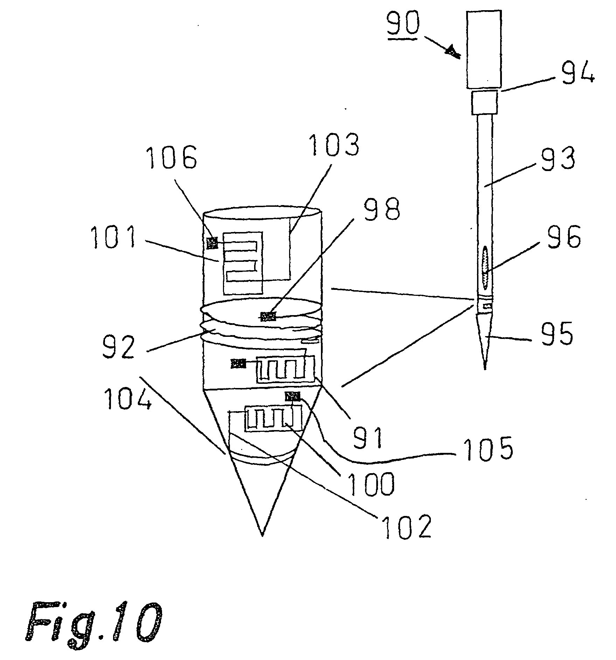

Eine weitere Ausführungsform einer Nähmaschinennadel ist, mit Detailansicht, **Figur 10** zu entnehmen. Zusätzlich zu dem Temperatursensor 91 sind dabei ein Verschleißsensor 100 sowie ein Kraft-/Dehnungssensor 101 angeordnet. Der Verschleißsensor ist in der Spitze 95 der Nadel angeordnet. Der Kraft-/Dehnungssensor ist hingegen auf dem Nadelkolben 93 oberhalb der Induktionsspule 92 angeordnet. Zum Abgreifen der Signale sind jeweilige Leiterbahnen 103 sowie 102 an den Sensoren 101 und 100 angeordnet. Der Verschleißsensor 100 weist zusätzlich noch eine Induktionsspule 104 auf. Diese ist im Bereich der Spitze angeordnet. Um eine gute Verbindung mit der Oberfläche der Nadel zu schaffen, sind im Bereich der Sensoren 91, 100, 101 jeweilige Kontaktflächen 98, 105, 106 angeordnet.

Eine Signalauskopplung kann dann über die Leiterbahnen und die entsprechenden Kontaktflächen am Nadelkolben bzw. auch an dem Nadeleinspannelement 94 erfolgen. Es kann auch eine telemetrische Übertragung realisiert werden, beispielsweise eine induktive, wobei der thermoresistive Sensor zur Temperaturmessung über die Leiterbahnen mit der aus wenigen Windungen bestehenden Induktionsspule 92 unten angeordnet ist. Vermittels von Durchkontaktierungen kann auch die Nadel selbst als Teil der Stromführung genutzt werden. Ist eine entsprechende Koppelspule vorgesehen, in welche die Nähnadel eintaucht, können die Signale dadurch ausgelesen werden. Hierbei kann auch eine kapazitive Kopplung realisiert werden.

Die Verschleißmessung vermittels des Verschleißsensors 100 erfolgt unter Auswertung einer Widerstandsänderung oder mittels der sequentiell durchtrennten Leiterbahnen.

### Bezugszeichenliste

- 1: mechanische Komponente / Element
- 2: Substrat

- 10: isolierende Schicht

- 20: Funktionsschicht
- 21: amorphe CH-Schicht
- 22: dotierter Bereich
- 23: Dotierung

- 30: sensorische Schicht / Leiterbahnschicht
- 31: Wegsensor

- 40: isolierende Schicht (Zwischenschicht)

- 50: Kolben
- 51: Zylinder
- 52: Kolbenstange
- 55: optischer Sensor
- 56: induktiver Sensor
- 57: Verschleißschutzschicht

- 60: thermoresistiver Sensor
- 61: Leiterbahn
- 62: induktive Signalauskopplung
- 63: Kontaktfläche

- 70: Achse
- 71: Lagerschale
- 72: Zustandssensor
- 73: Streifenefement
- 74: waagerechtes Streifenelement
- 75: Laserschnitt (senkrecht)
- 76: Laserschnitt (waagerecht)

- 80: Wendeschneidplatte
- 81: zentrale Öffnung
- 82: Zustandswandler
- 83: Leiterbahn
- 84: Kontaktfläche
- 85: Kantenbereich
- 86: Rand

- 90: Nähmaschinennadel
- 91: Temperatursensor
- 92: Induktionsspule
- 93: Nadelkolben
- 94: Einspannelement
- 95: Spitze
- 96: Langloch
- 97: Leiterbahn
- 98: Kontaktfläche

- 100: Verschleißsensor
- 101: Kraft-/Dehnungssensor
- 102: Leiterbahn
- 103: Leiterbahn
- 104: Induktionsspule
- 105: Kontaktfläche
- 106: Kontaktfläche

## Patentansprüche

1. Mechanisch beanspruchbare Komponente oder Element mit
- einem Substrat (2)
- einer darauf angeordneten isolierenden Schicht (10)
- und mindestens einer darauf angeordneten Funktionsschicht (20) mit sensorischen Eigenschaften,
wobei die Schichten (10, 20) aus amorphem Kohlenwasserstoff oder aus Bornitridsystemen bestehen,
**dadurch gekennzeichnet,**
**dass** die Schichten (10, 20) einen gemeinsamen monolithischen Aufbau bilden, und
**dass** sie sich chemisch lediglich durch eine voneinander verschiedene Dotierung mit anderen Materialien unterscheiden.

2. Komponente nach Anspruch 1,
**dadurch gekennzeichnet,**
**dass** die isolierende, insbesondere elektrisch isolierende Schicht (10) nicht oder nur mit Fluor dotiert ist.

3. Komponente nach Anspruch 1 oder Anspruch 2,
**dadurch gekennzeichnet,**
**dass** die Funktionsschichten (20) durch Metalle oder Metallverbindungen dotiert sind.

4. Komponente nach Anspruch 3,
**dadurch gekennzeichnet,**
**dass** als das oder eines der Metalle Titan oder eine Titanverbindung, Wolfram oder eine Wolframverbindung eingesetzt wird.

5. Komponente nach einem der vorhergehenden Ansprüche,
**dadurch gekennzeichnet,**
**dass** die Funktionsschicht (20) als strukturierte Sensor-Leiterebene ausgebildet ist.

6. Komponente nach Anspruch 5,
**dadurch gekennzeichnet,**
**dass** die mit Fremdelementen, insbesondere Metallen dotierte amorphe Kohlenwasserstoffschicht oder Bornitridschicht durch Laserbestrahlung strukturiert leitfähig ist.

7. Komponente nach einem der vorhergehenden Ansprüche,
**dadurch gekennzeichnet,**
**dass** gradierte Übergänge zwischen isolierender Schicht (10) und Funktionsschicht (20) vorgesehen sind.

8. Komponente nach einem der Ansprüche 3 bis 7,
**dadurch gekennzeichnet,**
**dass** die metallhaltige elektrisch leitende Schicht (20) eine Dicke im Bereich von 50 nm bis 10 µm aufweist.

9. Komponente nach einem der vorstehenden Ansprüche,
**dadurch gekennzeichnet,**
**dass** die Komponente ein Pneumatikzylinder mit einem Kolben und einer Kolbenstange und einem Zylinder ist, wobei die Kolbenstange mit einer amorphen metallhaltigen Kohlenwasserstoffschicht beschichtet ist, wobei Lasermarkierungen für eine Weg- oder Positionsmessung vorgesehen sind, oder
**dass** die Komponente ein Linearantrieb mit Laufflächen und Führungsschlitten ist, wobei die Laufflächen des Antriebes mit einer reibungsarmen Schicht in Form einer amorphen Kohlenwasserstoffschicht in Kombination mit einer metallhaltigen Kohlenwasserstoffschicht als Isolationsschicht zwischen dem metallischen Schlitten und einer tribologischen Funktionsschicht versehen ist, oder
**dass** die Komponente ein rotierender mechanischer Körper, insbesondere eine Achse oder Lagerschale von Gleitlagern ist, wobei die Achse mit einer amorphen Kohlenwasserstoffschicht und einer metallhaltigen amorphen Kohlenwasserstoffschicht beschichtet ist, wobei die amorphe Kohlenwasserstoffschicht eine Dicke im Bereich von 0,1µm bis 15 µm aufweist und
wobei die metallhaltige amorphe Kohlenwasserstoffschicht eine an die sensorische Funktion angepasste Dicke bei Anpassung der Dicke und Metalldotierung auf die jeweilige Anwendung aufweist, oder
**dass** die Komponente ein Zerspan- und Umformwerkzeug, insbesondere eine Wendeschneidplatte für die Zerspanung ist, wobei auf dieser ein auf Bornitrid basierendes Schichtsystem aufgebracht ist, welches eine titanreiche Bornitrid-Haftschicht, eine gradierte und eine reine Bornitridschicht aufweist, welche in kubischer Phase aufwächst und eine Schichtdicke im Bereich von 0,5 bis 10 µm aufweist, oder
**dass** die Komponente eine Nähmaschinennadel ist, bei der in dem monolithischen Aufbau Leiterbahnen und/oder Bereiche mit definiertem spezifischem Widerstand durch die Dotierung und die Laserbestrahlung gebildet sind, wobei eine Verschleißmessung und/oder Temperaturmessung auf der Nähnadel durch Auswerten einer Widerstandsänderung oder mittels sequentiell durchtrennter Leiterbahnen erfolgt.

10. Verfahren zum Herstellen von mechanisch beanspruchbaren Komponenten und Elementen nach einem der Ansprüche 1 bis 9 mit einem mit tribologischer Beschichtung zu versehenden Substrat, wobei
- die Komponente (1) oder das Element (50, 70, 80, 90) zumindest im Bereich des zu beschichtenden Substrates (2) gereinigt wird,
- auf der gereinigten Oberfläche eine isolierende Schicht (10) abgeschieden wird,
- auf der isolierenden Schicht eine oder mehrere weitere Schichten (20, 30, 40) oder ein Schichtsystem abgeschieden werden, wobei zumindest eine Funktionsschicht (20) vorgesehen ist.

## Claims

1. Mechanically resistant component or element with
- a substrate (2)
- an insulating layer (10) disposed thereon
- and at least one functional layer (20) disposed thereon with sensor properties,
wherein the layers (10, 20) are composed of an amorphous hydrocarbon or of boron nitride systems,
**characterised in that**
the layers (10, 20) form a common monolithic structure, and that they differ chemically only by different doping with other materials.

2. Component according to Claim 1,
**characterised in that**
the insulating, in particular electrically insulating layer (10) is not doped or is only doped with fluorine.

3. Component according to Claim 1 or Claim 2,
**characterised in that**
the functional layers (20) are doped by metals or metal compounds.

4. Component according to Claim 3,
**characterised in that**
titanium or a titanium compound, tungsten or a tungsten compound is used as the metal or one of the metals.

5. Component according to one of the preceding claims,
**characterised in that**
the functional layer (20) is configured as a structured sensor-conductor plane.

6. Component according to Claim 5,
**characterised in that**
the amorphous hydrocarbon layer or boron nitride layer doped with extraneous elements, in particular metals, is structured to be conductive by laser irradiation.

7. Component according to one of the preceding claims,
**characterised in that**
graduated transitions are provided between the insulating layer (10) and functional layer (20).

8. Component according to one of Claims 3 to 7,
**characterised in that**
the metal-containing, electrically conductive layer (20) has a thickness in the range of 50 nm to 10 µm.

9. Component according to one of the preceding claims,
**characterised in that**
the component is a pneumatic cylinder with a piston and a piston rod and a cylinder, said piston rod being coated with an amorphous, metal-containing hydrocarbon layer,
wherein laser markings are provided for a distance or position measurement, or
that the component is a linear drive means with running surfaces and guide carriage, said running surfaces of the drive means being provided with a low-friction layer in the form of an amorphous hydrocarbon layer in combination with a metal-containing hydrocarbon layer as insulating layer between the metal carriage and a tribological functional layer, or
that the component is a rotating mechanical body, in particular an axle or bearing shell of slide bearings, said axle being coated with an amorphous hydrocarbon layer and a metal-containing amorphous hydrocarbon layer, said amorphous hydrocarbon layer having a thickness in the range of 0.1 µm to 15 µm and said metal-containing amorphous hydrocarbon layer having a thickness adapted to the sensor function upon adaptation of the thickness and metal doping to the respective application, or
that the component is a cutting and forming tool, in particular a cutting plate insert for cutting, wherein a boron nitride-based layer system is applied thereon which has a boron nitride adhesive layer rich in titanium, a graduated and a pure boron nitride layer, which grows in the cubic phase and has a layer thickness in the range of 0.5 to 10 µm, or
that the component is a sewing machine needle, in which in the monolithic structure strip conductors and/or regions with defined resistivity are formed by the doping and the laser irradiation, wherein a wear measurement and/or temperature measurement is conducted on the sewing needle by evaluation of a change in resistance or by means of sequentially separated strip conductors.

10. Process for the production of mechanically resistant components and elements according to one of Claims 1 to 9 with a substrate to be provided with a tribological coating, wherein
- the component (1) or the element (50, 70, 80, 90) is cleaned at least in the region of the substrate (2) to be coated,
- an insulating layer (10) is deposited on the cleaned surface,
- one or more further layers (20, 30, 40) or a layer system are deposited on the insulating layer,
wherein at least one functional layer (20) is provided.

## Revendications

1. Composant ou élément pouvant être sollicité mécaniquement, comprenant
- un substrat (2)
- une couche isolante (10) agencée sur celui-ci
- et au moins une couche fonctionnelle (20) avec des propriétés sensorielles agencée sur celui-ci,
les couches (10, 20) étant composées d'hydrocarbure amorphe ou de systèmes de nitrure de bore, **caractérisé en ce que** les couches (10, 20) constituent une structure monolithique commune et **en ce qu'**elles se distinguent chimiquement uniquement par un dopage avec d'autres matériaux différents les uns des autres.

2. Composant selon la revendication 1, **caractérisé en ce que** la couche isolante (10), en particulier isolante électriquement, n'est pas dopée ou seulement dopée au fluor.

3. Composant selon la revendication 1 ou selon la revendication 2, **caractérisé en ce que** les couches de fonction (20) sont dopées par des métaux ou des composés métalliques.

4. Composant selon la revendication 3, **caractérisé en ce que** le métal ou l'un des métaux est le titane ou un composé de titane, le tungstène ou un composé de tungstène.

5. Composant selon l'une quelconque des revendications précédentes, **caractérisé en ce que** la couche fonctionnelle (20) est réalisée comme un plan conducteur à capteur structuré.

6. Composant selon la revendication 5 , **caractérisé en ce que** la couche d'hydrocarbure amorphe, ou la couche de nitrure de bore, dopée par des éléments extérieurs, en particulier des métaux, est conductrice de façon structurée par rayonnement laser.

7. Composant selon l'une quelconque des revendications précédentes, **caractérisé en ce que** des transitions graduées sont prévues entre la couche isolante (10) et la couche fonctionnelle (20).

8. Composant selon l'une quelconque des revendications 3 à 7, **caractérisé en ce que** la couche (20) électroconductrice métallifère présente une épaisseur dans la plage de 50 nm à 10 µm.

9. Composant selon l'une quelconque des revendications précédentes, **caractérisé en ce que** le composant est un cylindre pneumatique avec un piston et une bielle et un cylindre, la bielle étant recouverte d'une couche d'hydrocarbure amorphe métallifère, des marquages au laser étant prévus pour une mesure de déplacement et de position, ou **en ce que** le composant est une commande linéaire avec des surfaces de roulement et des coulisseaux, les surfaces de roulement de la commande étant munies d'une couche à faible friction sous forme d'une couche d'hydrocarbure amorphe en combinaison avec une couche d'hydrocarbure métallifère comme couche isolante entre le coulisseau métallique et d'une couche fonctionnelle tribologique,
ou **en ce que** le composant est un corps mécanique rotatif, en particulier un axe ou une coquille de coussinet de paliers lisses, l'axe étant recouvert d'une couche d'hydrocarbure amorphe et d'une couche d'hydrocarbure amorphe métallifère, la couche d'hydrocarbure amorphe ayant une épaisseur dans la plage de 0,1 µm à 15 µm et la couche d'hydrocarbure amorphe métallifère ayant une épaisseur adaptée à la fonction sensorielle, l'épaisseur et le dopage au métal étant adaptés à l'application respective, ou **en ce que** le composant est un outil à enlèvement de copeaux et formage, en particulier une plaquette amovible pour l'enlèvement de copeaux, un système de couches basé sur le nitrure de bore y étant appliqué, le système présentant une couche adhésive de nitrure de bore riche en titane, une couche de nitrure de bore graduée et une couche de bore de nitrure pure qui se forme en phase cubique et a une épaisseur de couche dans la plage de 0,5 à 10 µm, ou **en ce que** le composant est une aiguille de machine à coudre, dans laquelle, dans la structure monolithique, des pistes conductives et/ou des plages ayant une résistance spécifique définie sont formées par le dopage et le rayonnement laser, une mesure d'usure et/ou une mesure de température étant effectuée sur l'aiguille à coudre par évaluation d'une variation de résistance ou au moyen de pistes conductives séparées séquentiellement.

10. Procédé de fabrication de composants ou d'éléments pouvant être sollicités mécaniquement selon l'une quelconque des revendications 1 à 9 avec un substrat à munir d'un revêtement tribologique, dans lequel
- le composant (1) ou l'élément (50, 70, 80, 90) est nettoyé au moins au niveau du substrat à recouvrir (2),
- une couche isolante (10) est déposée sur la surface nettoyée,
- une ou plusieurs autres couches (20, 30, 40) ou un système de couches sont déposés sur la couche isolante, au moins une couche fonctionnelle (20) étant prévue.
